(19) **Europäisches Patentamt European Patent Office Office européen des brevets**

(11) **EP 2 100 308 B1**

(12) **EUROPÄISCHE PATENTSCHRIFT**

(45) Veröffentlichungstag und Bekanntmachung des Hinweises auf die Patenterteilung:
**06.07.2011 Patentblatt 2011/27**

(21) Anmeldenummer: **07870213.1**

(22) Anmeldetag: **05.12.2007**

(51) Int Cl.:
**G11C 29/02** (2006.01)

(86) Internationale Anmeldenummer:
**PCT/EP2007/063367**

(87) Internationale Veröffentlichungsnummer:
**WO 2008/068290 (12.06.2008 Gazette 2008/24)**

(54) **VERFAHREN UND HALBLEITERSPEICHER MIT EINER EINRICHTUNG ZUR ERKENNUNG VON ADRESSIERUNGSFEHLERN**

METHOD AND SEMICONDUCTOR MEMORY WITH A DEVICE FOR DETECTING ADDRESSING ERRORS

PROCÉDÉ ET MÉMOIRE À SEMI-CONDUCTEURS AVEC UN DISPOSITIF POUR LA RECONNAISSANCE D'ERREURS D'ADRESSAGE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **07.12.2006 DE 102006057700**
**05.12.2007 DE 102007058928**

(43) Veröffentlichungstag der Anmeldung:
**16.09.2009 Patentblatt 2009/38**

(73) Patentinhaber: **Continental Teves AG & Co. OHG 60488 Frankfurt (DE)**

(72) Erfinder:
• **FEY, Wolfgang**
**88131 Bodolz (DE)**
• **TRASKOV, Adrian**
**61449 Steinbach (DE)**
• **KABULEPA, Lukusa Didier**
**64390 Erzhausen (DE)**
• **AMJADI, Houman**
**76228 Karlsruhe (DE)**

(56) Entgegenhaltungen:
**EP-A- 0 451 985     EP-A- 1 662 511**
**US-A- 3 049 692     US-A- 4 912 710**

• **NICOLAIDIS M: "EFFECIENT UBIST IMPLEMENTATION FOR MICROPROCESSOR SEYUENCING PARTS" JOURNAL OF ELECTRONIC TESTING, KLUWER ACADEMIC PUBLISHERS, DORDRECHT, NL, Bd. 6, Nr. 3, 1. Juni 1995 (1995-06-01), Seiten 295-312, XP000519464 ISSN: 0923-8174**

**Beschreibung**

Die Erfindung betrifft ein Verfahren gemäß Oberbegriff von Anspruch 1 sowie einen Halbleiterspeicher oder ein datenverarbeitendes System gemäß Oberbegriff von Anspruch 7.

Es sind Fehlerüberwachungsverfahren in Halbleiterspeichern bekannt, mit denen Fehler von in Speicherzellen geladenen Datenbits erkannt und ggf. korrigiert werden können. Diese an sich bekannten Überwachungsverfahren können fehlerhafte Speicherzelleninhalte mit einem sehr hohen Abdeckungsgrad erkennen. Hierbei kommen beispielsweise fehlererkennende und -korrigierende Codes wie ECC (Error Correction Codes) zum Einsatz. Für den Schutz von Adressierungsschaltungen in Halbleiterspeichern sind diese bekannten Verfahren allerdings nicht ohne weiteres einsetzbar.

Bekanntlich können Adressierungsschaltungen überwacht werden, indem Adressbits in die Berechnung von redundanten Bits einbezogen werden. Dieses Prinzip erkennt jedoch keine Adressierungsfehler, die bereits vor dem Schreibzugriff vorgelegen haben. Beispielsweise, falls ein fehlerbehafteter Adressdekoder eine falsche Wortleitung auswählt, wird das zu schreibende Wort an einer falschen Adresse gespeichert. Bei, einem anschließenden Lesezugriff mit der gleichen Zieladresse wird das Wort ausgelesen, ohne dass der aufgetretene Fehler mittels der für die Adresse berechneten redundanten Bits erkannt wird.

Bei dem in der US 6,754,858 beschriebenen Verfahren werden fehlererkennende und -korrigierende Codes für die Schreibadressen in synchronen dynamischen RAM-Speichern (SDRAM: Synchronous Dynamic Random Access Memory) berechnet und gespeichert. Dazu wird ein Bitmuster für eine Folge von Schreibzugriffen generiert und mitgespeichert. Der Wert dieses Bitmusters hängt von den einzelnen Schreibadressen sowie von deren Reihenfolge ab. Zur Fehlererkennung wird nach einer Folge von Lesezugriffen ein nachgebildetes Bitmuster mit dem gespeicherten Bitmuster verglichen. Fehler, die in den Adressierungsschaltungen auftreten bzw. vorhanden sind, bewirken in der Regel Fehler in mehreren Bits. Die Fehlererkennungsrate bei Mehrbitfehlern ist für sicherheitskritische Anwendungen allerdings zu gering.

Weiterhin beruht die Fehlererkennung gemäß der US 6,754,858 auf der Annahme, dass die Adressierungsschaltungen während eines Schreibzugriffs fehlerfrei sind. Besonders im Falle von flüchtigen Speichern treten jedoch auch hier Fehler mit einer nicht zu vernachlässigbaren Häufigkeit auf. Bei nichtflüchtigen Speichern, wie z.B. Flash-ROMs, kann dagegen im Offline-Betrieb eine Überprüfung des Speichers vorgenommen werden, was bei flüchtigen Speichern nicht zielführend ist.

Bei der in der DE 43 17 175 A1 beschriebenen Selbsttesteinrichtung für Speicher werden Wortleitungen mittels eines Stromsensors überwacht. Ein durch die Sensorleitung fließender Strom soll auf einen Fehler hinweisen, wenn mehrere Auswahlleitungen gleichzeitig aktiviert werden. Die beschriebene Schaltungsanordnung kann jedoch keinen internen Fehler des Adressdekoders erkennen, wenn eine einzige, fehlerhaft adressierte Wortleitung ausgewählt wird. Das beschriebene Verfahren befasst sich zudem lediglich mit der Überwachung von Wortleitungen nach dem Adressdekoder und Adressleitungen vor dem Adressdecoder. In dem Adressdekoder sind jedoch ebenfalls Fehler möglich, bei denen eine einzige falsche Wortleitung trotz richtig angelegter Adressleitungen ausgewählt wird. Diese Fehlerart wird mit dem beschriebenen Verfahren nicht erkannt, da das Verfahren für die Erkennung der Auswahl mehrerer Wortleitungen ausgelegt ist.

Des Weiteren liefert die beschriebene Vorkehrung jedoch nur dann eine robuste Funktionalität, wenn jede Wortleitung nur an einer einzigen Stelle mit der Sensorleitung verbunden ist, zum Beispiel wenn $2^n$ Prüfleitungen für $2^n$ Wortleitungen verwendet werden. Allerdings tritt bei der Überwachung von $2^n$ Wortleitungen mit n Prüfleitungen das Problem von konkurrierenden Entladungs- und Aufladungsprozessen der Sensorleitung auf, wobei das Endergebnis von vielen Faktoren wie zum Beispiel von der Adresscodierung der betrachteten Wortleitung, MOS-Prozessparametern und parasitären Kapazitäten abhängig ist. Falls eine Wortleitung durch mehrere Transistor an der Sensorleitung verbunden ist, kann ein Transistor aufgrund des vorhandenen Fehlers die Sensorleitung entladen, während andere Transistoren die Sensorleitung gleichzeitig aufladen.

Eine falsche Wortleitungsauswahl lässt sich mit den in der US 49 12 710 und in der Veröffentlichung "Efficient UBIST Implementation for Microprocessor Sequential Partys"', M. Nicolaidis, IEEE International Test Conference, Juni 1990, beschriebenen Verfahren erkennen. In der US 49 12 710 erfolgt die Erkennung einer falschen Wortleitungsauswahl durch einen Vergleich der tatsächlich ausgewählten und der angelegten Adresse. Dennoch kann das in der US 49 12 710 dargestellte Verfahren keinen Kurzschluss zwischen Auswahlleitungen erkennen, bei dem die Adressbits einer Auswahlleitung die anderen Adressebits maskieren. Als Beispiel hierfür kann ein Kurzschluss zwischen den Wortleitungen erwähnt werden, die mit den Adressbits "111111...111" (alle haben den Wert Eins) und "110000 ... 000" ausgewählt werden.

In der vorstehend bezeichneten Veröffentlichung von Nicolaidis wird die tatsächlich ausgewählte Adresse mit einem einfachen Code und nicht mit den zu erwartenden Adressbit identifiziert. Um einen hohen Abdeckungsgrad bei der Erkennung von Adressierungsfehlern zu gewährleisten, weisen möglichst wenige Bitpositionen in den Codes einen logischen Wert "1" auf. Bei dem angeführten Beispiel mit sogenannten "1-aus-n Codes" besteht jeder Code aus einem einzigen logischein "1"-Wert und mehreren logischen "O"-Werten. Insbesondere bei großen Speichern führt diese Methode zu nachteilhaft langen Codes, denn je länger ein Code ist, umso höher sind die Hardware-Implementierungskosten des Verfahrens. Beispielsweise werden 1024 Adressprüfleitungen benötigt, um 10 Adressbits zu überwachen. Dazu kommt auch die Tatsache, dass das Prüfen der Übereinstimmung zwischen der angelegten Adresse und dem zurückgewonnenen Code ebenfalls komplexer wird. Aus diesen Gründen ist auch das in der Veröffentlichung beschriebene Verfahren mit einem sehr großen Hardware-Impementierungsaufwand verbunden.

Nächster Stand der Technick EP 1 662 511 A1 zeigt (z.B. Fig. 5) ein datenverarbeitendes System gemäß Präambel von Anspruch 1.

Der Erfindung liegt nun die Aufgabe zugrunde, ein Verfahren anzugeben, das eine zuverlässige Fehlerüberwachung von Adressierungsschaltungen und generell Speicherzugriffen in Halbleiterspeichern ohne einen großen Implementierungsaufwand erlaubt.

Diese Aufgabe wird gelöst durch das Verfahren gemäß Anspruch 1.

Zum Erkennen von Fehlern in der Adressierungsschaltung bzw. in einem ausgewählten Adressierungspfad wird zunächst ein Abgriff von logischen Pegeln an den Adressierungsleitungen, insbesondere an deren Terminierungen, vorgenommen. Weiterhin wird eine Darstellung der tatsächlich ausgewählten Adresse oder Teiladresse wird zusätzlicher Adressbitleitungen vorgenommen. Dann erfolgt eine Rückgewinnung der tatsächlich zugegriffenen Adresse/Teiladresse mit den Adressbitleitungen. Durch Vergleich der tatsächlich ausgewählten Adresse/Teiladresse mit der aus den zusätzlichen Adressbitleitungen gewonnenen, anliegenden Adressen/Teiladressen können schließlich Fehler in der Adressierungsschaltung bzw. in einem ausgewählten Adressierungspfad erkannt werden. Mit anderen Worten erfolgt beispielsweise für die Fehlererkennung eine Darstellung der tatsächlich ausgewählten Adresse durch die nach außen wiedergegebenen Adressbits und ein Vergleich der tatsächlich ausgewählten Adresse mit der angelegten Adresse.

Gemäß der Erfindung wird zur Fehlererkennung das elektrische Signal an den Adressierungsleitungen abgegriffen. Dies kann vorzugsweise an den Enden (Terminierungen) der Zeilen- und/oder der Spaltenauswahlleitungen für die Speicherzellen erfolgen.

Die Rückgewinnung der tatsächlich zugegriffenen Adresse/Teiladresse erfolgt bevorzugt in Form von Bitkomplementen (logischer Komplementärwert). Der Vergleich der rückgewonnenen Adresse/Teiladresse und ihrem Komplement:stellt eine interne Konsistenzprüfung der Rückgewinnung der Adresse/Teiladresse dar.

Das erfindungsgemäße Verfahren bietet den Vorteil, dass auftretende Fehler bereits unmittelbar nach einem Speicherzugriff erkannt werden können. Weiterhin kann eine Erkennung von Adressierungsfehlern nicht nur nach einer Leseoperation, wie bei bisher bekannten Verfahren, sondern auch nach einer Schreiboperation im laufenden Betrieb erfolgen. Ein weiterer Vorteil ist, dass das Fehlererkennungsverfahren zur Erkennung von Adressierungsfehlern nicht nur auf das Einzelfehlermodell, sondern auch auf die Erkennung von Mehrfachfehlern, wie Kurzschlüsse zwischen mehr als zwei Adressierungsleitungen, angewendet werden kann.

Besonders bevorzugt wird für die Rückgewinnung der Adresse/Teiladresse eine erste Konsistenzprüfung zwischen der rückgewonnenen Adresse/Teiladresse und deren Komplement sowie eine anschließende zweite Konsistenzprüfung zwischen der rückgewonnenen und der angelegten Adresse/Teiladresse durchgeführt, wobei die zweite Konsistenzprüfung insbesondere nur im Falle eines erfolgreichen Abschlusses der ersten Konsistenzprüfung durchgeführt wird. Hierdurch wird erreicht, dass der Maskierungsvorgang für Adressen und deren Komplemente unterschiedlich verlaufen kann und daher auch verschiedene Ergebnisse möglich sind.

Nach einer ersten bevorzugten Ausführungsform erfolgt die Verarbeitung der komplementierten und nicht komplementierten Bits in der Weise, dass die komplementierten und nicht komplementierten Bits ODER-Gattern zugeführt werden. Besonders bevorzugt werden dabei jeweils Gruppen von komplementierten Bits mehreren ODER-Gattern für das Komplement zugeführt und jeweils Gruppen von nichtkomplementierten Bits mehreren ODER-Gattern für das nicht komplementierte Signal zugeführt. Die Ausgänge der ODER-Gatter mit dem Komplement und den Ausgängen mit den unkomplementierten Signalen werden insbesondere einem oder mehren XNOR-Gattern zugeführt. Die erste bevorzugte Ausführungsform zeichnet sich durch einen geringen Aufwand an zusätzlichen elektronischen Bauelementen aus und ist insbesondere für eine kleine Anzahl von Auswahlleitungen vorteilhaft.

Nach einer zweiten bevorzugten Ausführungsform erfolgt die Verarbeitung der komplementierten und nicht komplementierten Bits in der Weise, dass neben der Speichermatrix eine zusätzliche Kodiermatrix und eine zusätzliche Komplementkodiermatrix vorgesehen ist. Die Anzahl der zusätzlichen Bitleitungen entspricht der doppelten Anzahl der Adressleitungen. In den Kreuzungspunkten dieser Matrizen sind insbesondere in geeigneter Weise Adress-Echo-Zellen angeordnet. Bei den Adress-Echo-Zellen handelt es sich bevorzugt um eines oder mehrere Halbleiterbauelemente, die mit den gekreuzten, die Matrizen bildenden, Leitungen so verschaltet sind, dass Signalbits oder Komplemente Signalbits erzeugt werden. Die zweite bevorzugte Ausführungsform ist dann vorteilhaft, wenn eine große Anzahl von Auswahlleitungen (für die Zeilen und oder Spalten) im Speicher benötigt wird. Die zweite bevorzugte Ausführungsform ermöglicht zudem eine besonders schnelle Verarbeitung mit geringem Taktzyklenverbrauch, da die interne Überprüfung der Adressen gleichzeitig mit dem Zugriff auf die Speicherzellen stattfindet. Hierdurch kann zum Beispiel die Anzahl von schlafenden Fehlern in Halbleiterleiterspeichern reduziert werden. Mit herkömmlichen Überwachungsverfahren verweilt ein durch verfälschte Adressierung entstandener Fehler so lange im Speicher, bis er nach einem Lesezugriff auf die betroffene Adresse erkannt wird. Vorteilhaft ist zudem, dass der Aufwand von Testalgorithmen für Halbleiterspeicher deutlich gemindert werden kann.

Vorzugsweise wird gemäß dem Verfahren die Rückgewinnung der tatsächlich zugegriffenen Adresse auch überwacht, in dem eine unabhängige Rückgewinnung des binären Komplements der tatsächlich zugegriffenen Adresse durchgeführt wird.

Bevorzugt wird zwischen Adressierungsfehlern und Datenfehlern eindeutig und als solche erkennbar unterschieden. Dadurch bietet sich das Verfahren als geeignete Ergänzung von den an sich bekannten, auf redundanten Bits basierenden Fehlererkennungsmethoden an, die bisher ausschließlich für die Fehlererkennung im Datenbitbereich eingesetzt wurden.

Gemäß einer bevorzugten Variante des Verfahrens wird die Adressierungsprüfung im gleichen Zugriffszyklus einer Lese- oder Schreiboperation vorgenommen. Somit liegt das Ergebnis der Fehlerprüfung schon während des Lese- bzw. Schreibzyklusses vor, wodurch die Reaktionszeit im Falle eines Adressierungsfehlers sehr gering gehalten wird. Dieser Vorteil gilt sowohl für flüchtige als auch für nichtflüchtige Halbleiterspeicher.

Gemäß einer anderen bevorzugten Variante des Verfahrens werden die bei einem Speicherzugriff tatsächlich zugegriffene rückgelesene Adresse und/oder die komplementäre tatsächlich zugegriffene rückgelesene Adresse in einem oder jeweils einem Register gespeichert. Ein Speicherzugriff wird dann als fehlerfrei angesehen, wenn der Registerinhalt der Zugriffadresse bzw. dem Komplement der Zugriffadresse entspricht.

Die immer kleiner werdenden Strukturgrößen von Halbleiterprozessen führen dazu, dass flüchtige Halbleiterspeicher immer anfälliger auf sogenannte Soft-Errors werden. Diese Art von Fehlern, bei denen einzelne Bits "umkippen" werden im wesentlichen durch Alphateilchen oder kosmische Strahlung verursacht. Die Auftrittsrate von Soft-Errors lässt sich für einen neu entwickelten Speicher im Vorfeld abschätzen, indem dieser einer erhöhten geeigneten Bestrahlung unterzogen wird. Bisher wurden bei Testverfahren dieser Art alle auftretenden Fehler gezählt und protokolliert. Hierbei wird in der Regel nicht darauf geachtet, dass Adressierungsschaltungen und Speicherzellen bei einem vorliegenden Halbleiterspeicher unterschiedlich von Soft-Errors betroffen sein können. Nach einer bevorzugten Ausführungsform des Verfahrens ist es daher vorgesehen, eine eindeutige Unterscheidung zwischen Soft-Errors in Datenbits und Soft-Errors in den Adressierungsschaltungen vorzunehmen. Dabei wird besonders bevorzugt ein nicht reproduzierbarer Fehler genau dann als Soft-Errors in den Adressierungsschaltungen eingestuft, wenn die komplementären und nicht komplementären rückgewonnenen Adressen/Teiladressen eine Konsistenz aufweisen und gleichzeitig nicht zu der tatsächlich angelegten Adresse passend sind, und ein Soft-Errors einem Datenbit zugeordnet, wenn Bitfehler mittels eines Fehlererkennungsmechanismus bei einer einwandfreien Rückgewinnung der Adresse/Teiladresse erkannt werden.

Die Erfindung betrifft auch einen Halbleiterspeicher oder ein datenverarbeitendes System gemäß Anspruch 7, welcher/welches insbesondere derart ausgelegt ist, dass das weiter oben beschriebene Fehlererkennungsverfahren darin ausgeführt wird. Der Halbleiterspeicher, welcher insbesondere Teil des datenverarbeitenden Systems ist, umfasst neben der Adressierungsschaltung als Kernstruktur eine Speichermatrix, die von der Adressierungsschaltung adressiert wird.

Im erfindungsgemäßen Halbleiterspeicher sind Schaltungsmittel vorgesehen, die eine interne Erkennung und von Adressierungsfehlern durch Überwachung der darin enthaltenen Adressierungsschaltung erlauben. Es ist bevorzugt, dass zusätzlich zu den besagten Erkennungsmitteln für Adressierungsfehler auch Erkennungsmittel für Speicherfehler vorhanden sind.

Der erfindungsgemäße Halbleiterspeichers mit Fehlerüberwachung weist außerdem bevorzugt eine Adressierungsschaltung mit mindestens einem Rückkopplungspfad für die Überwachung auf. Hierdurch wird eine Verbesserung der Fehlerüberwachung und generell von Speicherzugriffen erreicht. Ausgehend vom schreibenden oder lesenden Mikroprozessor umfasst der Rückkopplungspfad insbesondere die Adressleitungen bis zum Speicher, den zu überwachenden Speicher und einen Rückführungspfad vom peripheren Adressbereich zurück zum Prozessor.

Bekanntlich wird der Zugriff des Prozessorkerns, welcher auf ein Speichermodul erfolgt, durch einen Speichercontroller bewerkstelligt. Der Prozessorkern und der Speichercontroller sind bevorzugt Teil eines datenverarbeitenden Systems, insbesondere eines Mikrocontrollers.

Bekannte Speichercontroller beinhalten in der Regel bereits Register, die Konfigurationsdaten enthalten. In diesen sind z.B. Werte mit der Anzahl von Wartezyklen abgelegt. Der Registersatz vom Speichercontroller wird bevorzugt um mindestens ein Adress-Echo-Register zur Überwachung des Adressdecoders ergänzt. Der Halbleiterspeicher gemäß der Erfindung ist also bevorzugt mit einem Speichercontroller verbunden oder enthält einen Speichercontroller, welcher eines oder mehrere Konfigurationsregister zur Überwachung des Adressdekoders umfasst. Nach jedem Speicherzugriff kann insbesondere in das Adress-Echo-Register die tatsächlich zugegriffene Adresse eingetragen werden.

Alternativ oder zusätzlich umfasst der Speichercontroller vorzugsweise ein Komplementadress-Echo-Register. In das Adress-Echo-Register wird die komplementäre zugegriffene Speicheradresse geschrieben. Das Komplementadress-Register spiegelt Fehlermeldungen ("Error Flags") aus der Überprüfung der Adressierungsschaltkreise wieder. Das Mikroprozessorsystem umfasst zweckmäßigerweise Mittel, die ein Auslesen des Adress-Echo-Registers oder des Komplementadress-Echo-Registers ermöglichen.

Das datenverarbeitende System, das mit dem Speichercontroller verbunden ist, ist umfasst bevorzugt neben Speicherzugriffsmitteln und Adressrücklesemitteln mindestens ein Vergleichsmittel, insbesondere mindestens ein Fehlererkennungsmittel, das einen Adressierungsschaltkreis dann als fehlerfrei erkennt, wenn der Inhalt von Adress-Echo-Register oder von Komplementadress-Echo-Register die Adresse vom letzten Speicherzugriff wiedergeben und insbesondere keine Fehlermeldung erfolgt. Der Mikroprozessor kann jederzeit oder bevorzugt in regelmäßigen Zeitabständen diese Überprüfung durchführen. Die Erfindung bezieht sich daher auch gesondert auf ein entsprechend erweitertes datenverarbeitendes System.

Das Adress-Echo-Register und/oder das Komplementadress-Echo-Register enthält vorzugsweise das oder die folgenden Bit(s), wobei eines oder mehrere der Bits einzeln oder in beliebiger Kombination bevorzugt sind:

a) Addressfehlerbit. Das Adressfehlerbit erzwingt einen Fehler bei der Rückgewinnung der Adresse.

b) Komplementärfehlerbit. Das Komplementärfehlerbit erzwingt einen Fehler bei der Rückgewinnung der komplementären Adresse.

c) Adressmodusbit. Das Adressmodusbit legt fest, ob das Adress-Echo-Register für alle Speicherzugriffe oder nur für fehlerhaften Speicherzugriffe verwendet wird. Im letzten Fall gilt das Verhalten nicht nur für Adressierungsfehler, sondern auch für Datenfehler wie zum Beispiel ECC-Fehler.

d) Komplement-Adressmodusbit. Das Komplement-Adressmodusbit legt fest, ob das Komplementadress-Echo-Register für alle Speicherzugriffe oder nur für fehlerhafte Speicherzugriffe verwendet wird. Im letzten Fall gilt das Verhalten nicht nur für Adressierungsfehler, sondern auch für Datenfehler wie zum Beispiel ECC-Fehler.

Mit den erzwungenen Fehlern kann der Prozessor auf besonders einfache Weise die Integrität der Anordnung zur Überwachung von Adressierungsschaltkreisen jederzeit oder bevorzugt in regelmäßigen Zeitabständen überprüfen.

Ein wichtiger Vorteil der vorstehend beschriebenen Ausführungsform ist es, dass eine sehr hohe Fehlerabdeckung bei der Überwachung von Adressierungsschaltungen ohne Änderungen im Prozessor und in dessen Schnittstellen erreicht wird. Die Erweiterungen im Speicher und im Speichercontroller können ohne Einschränkung auf beliebige Plattformen portiert werden.

Bei den erfindungsgemäßen Halbleiterspeichern handelt es sich bevorzugt um Schreib-/Lesespeicher oder Flash-ROMs.

Bevorzugt sind im Halbleiterspeicher weiterhin Hardwaremittel, wie insbesondere Fehlerspeichermittel, wie z.B. Fehlerspeicher oder Fehlerregister, vorhanden, mit denen Fehler in den Adressierungsschaltungen nach einem Speicherzugriff erkannt werden können. Hierdurch ergibt sich eine kurze Erkennungszeit für Adressierungsfehler, was besonders für echtzeitfähige und sicherheitskritische Anwendungen von Vorteil ist. Besonders bevorzugt wird die tatsächlich zugegriffene Adresse und die angelegte Adresse unmittelbar nach Erkennung eines Adressierungsfehler in einem Fehlerspeicher abgespeichert, wobei der Fehlerspeicher für eine nachträgliche Fehleranalyse zu einem späteren Zeitpunkt ausgelesen wird. Ganz besonders bevorzugt werden hierzu nach jeder Erkennung eines Adressierungsfehlers sämtliche vorhandene Adresswerte (d.h. tatsächlich angelegte Adresse/Teiladresse, komplementäre und nicht komplementäre rückgewonnene Adresse/Teiladresse) in Registern der Speicherschnittstelle gespeichert.

Weiterhin sind im Halbleiterspeicher nach der Erfindung bevorzugt Hardware-Zählmittel vorhanden, mit denen eine quantitative Ermittlung der Häufigkeit von Adressierungsfehler durchgeführt werden kann. Außerdem ist es bevorzugt, dass weitere Hardware-Zählmittel vorhanden sind, mit denen auch eine quantitative Ermittlung der Häufigkeit von Speicherzellen durchgeführt werden kann. Die vorstehend genannten Zählmittel sind insbesondere in Kombination miteinander vorhanden.

Für die Fehlererkennung ist bevorzugt im Halbleiterspeicher für jede Bitposition in der Adresse eine zusätzliche Bitleitung angelegt. Die Adressierungsschaltung umfasst weiterhin bevorzugt sowohl Zeilen- als auch Spaltenauswahlleitungen, wobei durch Terminierung der Zeilen- und Spaltenauswahlleitung mittels ODER-Gattern und/oder Adress-Echo Zellen die entsprechenden Adressbits nach außen wiedergegeben werden können. Auf diese Weise kann der Aufwand für die Rückgewinnung von Adressbits gering gehalten werden.

Zur Bildung einer Adress-Echo Zelle wird an den Kreuzungen der zusätzlichen Bitleitung mit einer entsprechenden Zeilen- oder Spaltenauswahlleitung bevorzugt ein Halbleiterelement (zum Beispiel ein MOS-Transistor) angeschlossen. Dieser schaltet zweckmäßigerweise durch, falls die entsprechende Bitposition für die betrachtete Zeilen- oder Spaltenauswahlleitung aktiv ist. Wenn eine Auswahlleitung aktiv getrieben wird, fließt ein Strom durch die zusätzliche Bitleitung. Außerdem bevorzugt sind zusätzlich Leseverstärker für die Signale der Bitleitungen vorgesehen, die die tatsächliche Zugriffsadresse wiedergegeben.

Der obige Halbleiterspeicher wird bevorzugt in mikroprozessorgesteuerten Kraftfahrzeugregelsystemen, die sicherheitskritische Funktionen ausführen, oder in computergesteuerten Echtzeitsystemen verwendet.

Weitere bevorzugte Ausführungsformen ergeben sich aus den Unteransprüchen und der nachfolgenden Beschreibung von Ausführungsbeispielen an Hand von Figuren.

Es zeigen

Fig. 1  eine schematische Darstellung des Fehlererken- nungsteils in dem erfindungsgemäßen Halbleiter- speicher,

Fig. 2  einen gegenüber Fig. 1 abgewandelten Fehlererken- nungsteil eines erfindungsgemäßen Speichers,

Fig. 3  eine Adress-Echo Zelle im Fehlerkennungsteil von Fig. 2,

Fig. 4  ein Beispiel für die Einbindung des Fehlererken- nungsteils gemäß Fig. 2 in eine herkömmliche Ar- chitektur eines Halbleiterspeichers,

Fig. 5  sein erfindungsgemäß erweitertes datenverarbeiten- des System,

Fig. 6  eine erweiterte Adressierungsschaltung zur Stimu- lation von Adressierungsfehlern mittels Konfigura- tionsbits und

Fig. 7  eine weitere Adressierungsschaltung zur Stimulati- on von Adressierungsfehler, welche gegenüber Fig. 6 vereinfacht ist.

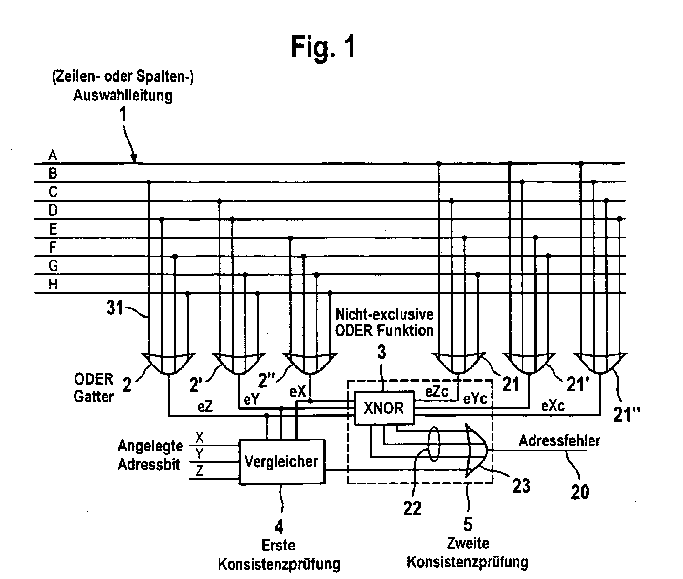

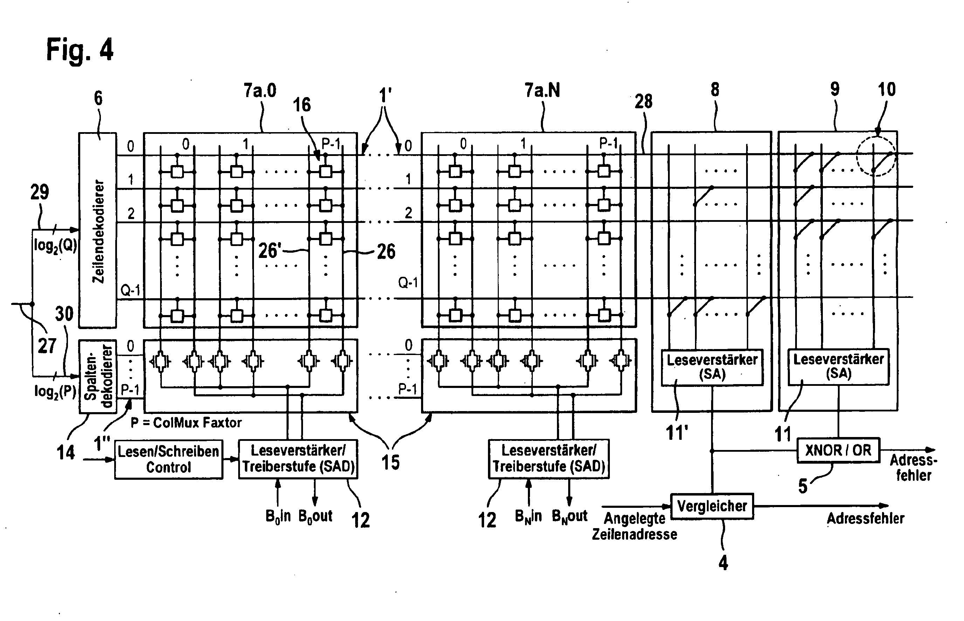

In Fig. 1 sind acht Spaltenauswahlleitungen 1 (A, B, C, D, E, F, G und H) innerhalb eines Adressdekoders dargestellt, wie er in einem Halbleiterspeicher gemäß Fig. 4 zum Einsatz kommt. Aus drei angelegten Adressbits X, Y und Z selektiert ein nicht in Fig. 1 dargestellter Adressdekoder (siehe Fig. 4) jeweils eine der acht Auswahlleitungen 1. Hierbei entsprechen die Auswahlleitungen 1 (A, B, C, D, E, F, G und H) jeweils den Adressen "000", "001", "010", "011", "100", "101", "110" und "111". An den Terminierungen der acht Auswahlleitungen 1 sind die Eingänge der ODER-Gatter 2, 2' und 2 " angeschlossen. Die Ausgänge der ODER-Gatter 2, 2' und 2" erzeugen wiedergewonnene Adressbits eX, eY und eZ aus den Adressleitungen entsprechend folgendem Schema:

$$eZ \ = \ B \ + \ D \ + \ F \ + \ H$$

$$eY \ = \ C \ + \ D \ + \ G \ + \ H$$

$$eX \ = \ E \ + \ F \ + \ G \ + \ H$$

Es wird demzufolge nur jede zweite Leitung einem ODER-Gatter zugeführt. In Vergleicher 4 wird mit den Signalen eX, eY und eZ eine erste Konsistenzprüfung vorgenommen, wobei die wiedergewonnenen Adressbits eX, eY und eZ mit den tatsächlich angelegten Adressbits X, Y und Z verglichen werden. Falls die verglichenen Bits nicht alle übereinstimmen, wird ein Adressfehler an Leitung 20 signalisiert.

Es gibt allerdings Adressfehlermuster die bei der ersten Konsistenzprüfung durch Vergleicher 4 nicht erkannt werden können. Tritt zum Beispiel ein Kurzschluss zwischen den Auswahlleitungen E und F auf, sind die entsprechenden Adressbit jeweils "100" und "101". Die erste Konsistenzprüfung kann diesen Kurzschluss nur dann als Adressfehler detektieren, wenn ein Speicherzugriff auf die Auswahlleitung E erfolgt. Bei einem Speicherzugriff auf die Auswahlleitung F kann die erste Konsistenzprüfung alleine einen Kurzschluss zwischen den zwei Auswahlleitungen E und F nicht erkennen. Um einen noch höheren Abdeckungsgrad bei der Erkennung von Adressierungsfehlern zu erzielen, wird die Fehlerkennung auch auf Basis der Komplemente mittels der zusätzlichen ODER-Gatter 21, 21' und 21" durchgeführt, deren Eingänge ebenfalls an den Terminierungen der acht Auswahlleitungen A, B, C, D, E, F, G und H angeschlossen sind, wobei die Zuordnung zu den Leitungen gegenüber der Zuordnung der Gatter 2 komplementär ist. Dabei werden die Leitungen verwendet, die bei den Gattern 2 ausgelassen sind. Die drei zusätzlichen ODER-Gatter 21, 21' und 21" bilden die drei komplementären Adressbits eXc, eYc und eZc entsprechend folgender Zuordnung:

$$eZc \ = \ A \ + \ C \ + \ E \ + \ G$$

$$eYc \ = \ A \ + \ B \ + \ E \ + \ F$$

$$eXc \ = \ A \ + \ B \ + \ C \ + \ D$$

Die wiedergewonnenen Adressbit eX, eY und eZ sowie deren abgeleiteten komplementären Werte eXc, eYc und eZc werden dann für eine zweite Konsistenzprüfung (gestrichelter Block 5) einer Gruppe von Exlusiv-ODER Gattern 3 zugeführt. Die Ausgänge 22 der Gruppe von Exklusiv-ODER Gattern 3 ist dem Eingang von ODER-Gatter 23 zugeführt. Die zweite Konsistenzprüfung 5 signalisiert immer dann einen Fehler, wenn die Bits eX, eY, eZ und die Bits eXc, eYc, eZc nicht komplementär zueinander sind. Insgesamt werden in der zweiten Konsistenzprüfung für acht Auswahlleitungen lediglich sieben ODER Gatter mit jeweils vier Eingängen, ein exklusives ODER Gatter und ein exklusives NICHT- ODER Gatter (XNOR) benötigt. Aufgrund dieser geringen Anzahl von logischen Gattern ermöglicht das erfindungsgemäße Verfahren eine Überprüfung der Adressierungsschaltungen im gleichen Zugriffszyklus wie die laufende Lese- oder Schreiboperation. Die Fehlererkennungsschaltung lässt sich dem obigen Prinzip folgend auch auf eine höhere Anzahl von Auswahlleitungen anwenden. Allerdings müssen dann längere Überprüfungszeiträume in Kauf genommen werden.

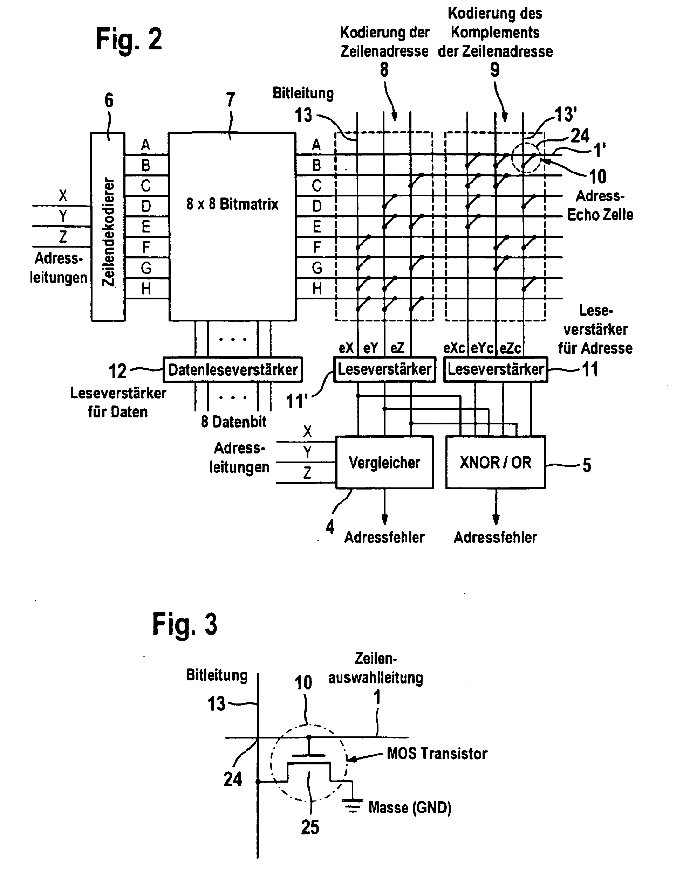

Der in Fig. 2 dargestellte Fehlererkennungsteil des Halbleiterspeichers entspricht weitestgehend dem Prinzip der Schaltung in Fig. 1, jedoch ist die schaltungstechnische Umsetzung noch weiter optimiert. Es bestehen dabei im wesentlichen Unterschiede zu den in Fig. 1 dargestellten Verknüpfungen der Auswahlleitungen mit ODER-Gattern 2 und 21. Die Fehlererkennungsschaltung in Fig. 2 ermöglicht eine Fehlererkennung auch bei einer erheblich höheren Anzahl von Zeilenauswahlleitungen (zum Beispiel mehr als 256) innerhalb eines einzigen Lese/Schreibzyklusses. Die dargestellte Schaltung entspricht im Prinzip der Fehlererkennungseinrichtung in Fig. 1, wobei jedoch eine Schaltungserweiterung vorgenommen wurde. Zur vereinfachten Darstellung sind lediglich acht Zeilenauswahlleitungen A, B, C, D, E, F, H und G gezeichnet (Bezugszeichen 1'). Zusätzlich zur Schaltung in Fig. 1 sind mit den Adressleitungen Bitleitungen 13 nach dem Prinzip einer Bitmatrix verbunden. An jedem Kreuzungspunkt zwischen Zeilenauswahlleitung (Bitleitung; zum Beispiel Punkt 24) wird eine Adress-Echo-Zelle 10 angeordnet. Die Adress-Echo-Zellen 10 führen zu einer festen Programmierung der Adressbits am Ende jeder einzelnen Zeilenauswahlleitung und bilden eine Struktur mit logischen NICHT-ODER-Verknüpfungen.

Innerhalb des Kodierers 8 werden die mit den Zeilenadressleitungen verbundenen Bitleitungen 13 über Leseverstärker 11 und 11' verstärkt. Leseverstärker 11' umfasst logische Inverter, da die ODER-Funktion in den Adress-Echo-Zellen 10 negiert ausgegeben werden. In einer Adress-Echo-Zelle 10 kann ein Bitwert "1" oder ein Bitwert "0" ausgelesen werden. Leseverstärker 11' für die Adressleitungen entspricht weitestgehend dem Aufbau eines herkömmlichen Datenleseverstärkers 12, wobei allerdings geringfügige Anpassungen notwendig sind.

In einem weiteren Kodierer 9 werden die komplementären Bits für die Zeilenadresse festgelegt. Auch hier ist ein invertierender Leseverstärker 11 mit den Adress-Echo-Zellen 10 verbunden. Kodierer 8 bildet die Eingangsleitungen eX, eY und eZ entsprechend Fig. 1 für die erste Konsistenzprüfung 4. Kodierer 9 bildet die komplementären Leitungen eXc, eY und rZc für die zweite Konsistenzprüfung 5. Man beachte hierbei, dass das Anordnen von Adresskodierungsmodulen 8 und 9 an den Terminierungen der Auswahlleitungen eine Überwachung von vollständigen Adressierungspfaden ermöglicht.

Der Geschwindigkeitsvorteil der Schaltung in Fig. 2 ergibt sich daraus, dass die benötigten Adressinformationen auf sehr ähnliche Weise wie Datenbits aus der Speichermatrix 7 gewonnen werden.

In Fig. 3 ist der Aufbau einer Adress-Echo-Zelle 10 dargestellt. Adress-Echo-Zelle 10 besteht aus einem einzigen MOS-Transistor 25. Der Gate-Anschluss des MOS-Transistors ist mit Zeilenauswahlleitung 1' verbunden, während die Drain-Elektrode an der Bitleitung 13' angeschlossen ist. Die Source-Elektrode wird auf ein Referenzpotential gelegt.

Die Darstellung in Fig. 4 zeigt die Implementierung des Fehlererkennungsteils gemäß Fig. 2 in eine an sich bekannte Architektur eines Halbleiterspeichers (SRAM, DRAM, ROM, Flash-ROM). Die Speicherzellen 16 befinden sich an den Kreuzungspunkten der Zeilenauswahlleitungen 1 mit den Spaltenauswahlleitungen 26, 26'. Für eine Wortbreite von N Bits ist die Architektur in N Teilmatrizen 7a.0 ... 7a.N aufgeteilt, so dass jede Teilmatrix eine Bitposition eines zu schreibenden oder zu lesenden Wortes speichert. Somit speichert die Teilmatrix (7a.0) alle sich an der Position Null befindenden Bits für alle Wörter.

Für eine Anzahl von Q Zeilenauswahlleitungen 1 werden $\log_2$ Q Zeilenauswahlbits 29 von den Adressbits 27 benötigt. Diese werden von Zeilendekoder 6 dekodiert und münden in Zeilenauswahlleitungen 1'. An den Terminierungen 28 der Zeilenauswahlleitungen 1' wird die Fehlererkennungsschaltung entsprechend Fig. 2 angeschlossen. Die Kodierer 8 und 9 sowie die Leseverstärker 11 und 11' wurden ebenfalls bereits im Zusammenhang mit Fig. 2 erläutert. Auch die erste und zweite Konsistenzprüfung (Bezugszeichen 4 und 5) entspricht dem Schaltungsbeispiel in Fig. 2.

Der in Fig. 4 dargestellte Speicher umfasst weiterhin einen Spaltendekoder 14, der mit Spaltenauswahlleitungen 1 " verbunden ist. Die Spaltenauswahlleitungen 1" dienen zur Ansteuerung der Spaltenmultiplexer 15. Entsprechend der Fehlerüberwachung für die Zeilenauswahlleitungen 1' können nun auch die Spaltenauswahlleitungen 1" dem Prinzip in Fig. 1 oder 2 folgend überwacht werden. Für P Spaltenauswahlleitungen werden $\log_2$ P Spaltenadressbits 30 benötigt. Üblicherweise ist die Anzahl von Spaltenauswahlleitungen 1" wesentlich geringer, als die von Zeilenauswahlleitungen 1'. In Fällen von Speicherarchitekturen mit einer geringen Anzahl von Spaltenauswahlleitungen kann das Schaltungsbeispiel in Fig. 1 zumindest für die Fehlererkennung bei den Spaltenauswahlleitungen vorteilhaft gegenüber dem Schaltungsbeispiel in Fig. 2 sein.

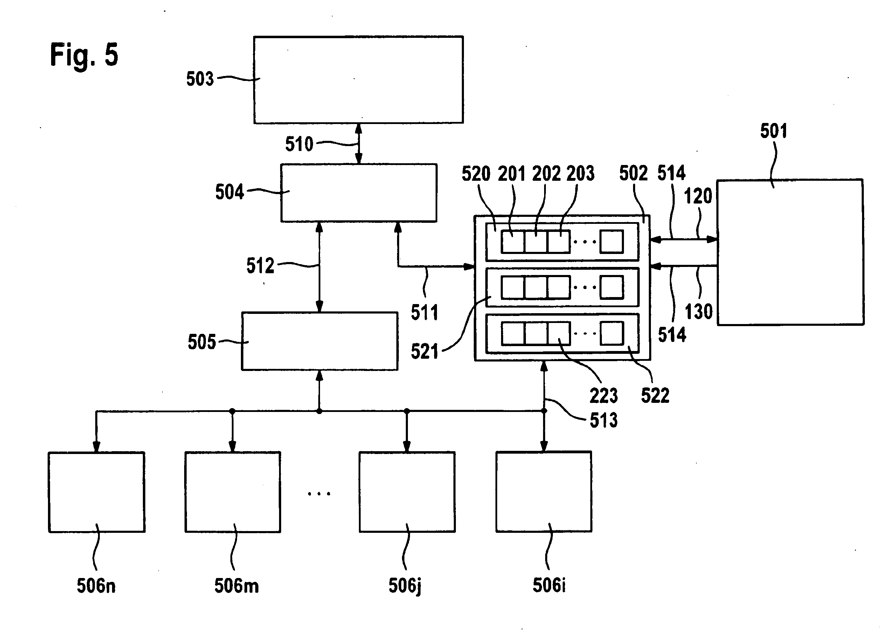

An Hand von Fig. 5 wird die prinzipielle Hardwarearchitektur eines beispielgemäßen datenverarbeitenden Systems, welches insbesondere ein Mikrocontroller ist, dargestellt. Prozessor 503 ist über Bus 510 mit Busmatrix 504 verbunden. Bus 510 kann beispielsweise nach dem AHB (Advanced High-Performance Bus)-Protokoll implementiert sein. Auf der Slave-Seite der Busmatrix 504 können verschiedene Module angeschlossen werden. Der Einfachheit halber sind nur die zwei Slave-Module Peripheriebrücke (Peripheral Bridge) 505 und Speichercontroller 502 dargestellt. Die Busse 511 und 512 können dabei das gleiche Busprotokoll wie Bus 510 nutzen. Speichercontroller 502 und Speicher 501 sind über den lokalen Bus 514 verbunden. In vielen bekannten Architekturen können die Register des mit Speicher 501 verbundenen Speichercontrollers 502 wie Register von den Peripherieeinheiten 506n, 506m, 506j und 506i über den Peripheriebus 513 und die Peripheriebrücke 505 ausgelesen und beschrieben werden. Die Anzahl von Wartezyklen für Speicherzugriffe mittels Konfigurationsregister kann im Speichercontroller 502 eingestellt werden.

Speichercontroller 502 weist folgende Register auf:

- Adress-Echo Konfigurationsregister 520,
- Adress-Echo-Testregister 521 und
- Komplementäradress-Echo-Register 522

Das Adress-Echo Konfigurationsregister 520 beinhaltet dabei folgende Bits:

- Adressfehlerbit 201
- Komplementärfehlerbit 202
- Adressmodusbit 203

Analog sind auch entsprechende Bits in den Registern 521 und 522 vorgesehen. Das Adressfehlerbit 201 erzwingt einen Fehler bei der Rückgewinnung der Adresse. Das Komplementärfehlerbit 202 erzwingt einen Fehler bei der Rückgewinnung der komplementären Adresse. Das Adressmodusbit 203 legt fest, ob das Adress-Echo-Testregister 521 für alle Speicherzugriffe oder nur für fehlerhafte Speicherzugriffe verwendet wird. Im letzten Fall gilt das Verhalten nicht nur für Adressierungsfehler, sondern auch für Datenfehler wie zum Beispiel ECC-Fehler. Das Komplementadressmodusbit 223 legt fest, ob das Komplementäradress-Echo-Register 522 für alle Speicherzugriffe oder nur für fehlerhafte Speicherzugriffe verwendet wird. Im letzten Fall gilt das Verhalten nicht nur für Adressierungsfehler, sondern auch für Datenfehler wie zum Beispiel ECC-Fehler.

Nach einem Speicherzugriff können Werte von Adressbits im Adress-Echo-Testregister 521 festgehalten werden. Entsprechend können Werte der komplementären Adressbits im Komplementäradress-Echo-Register festgehalten werden. Hierfür wir die zwischen Speichercontroller 502 und Speicher 501 vorhandene Schnittstelle 120 um die Echo-Adressleitungen 130 erweitert.

Mikroprozessor 503 kann über den durch den mit den Bezugszeichen 510, 504, 512, 505 und 513 bezeichneten Signalpfad überprüfen, ob die Adressierungsschaltung in Speicher 501 einwandfrei funktioniert. Dabei werden auch die Adressleitungen sowie deren Weiterschaltung durch die Busmatrix 504 und den Speichercontroller 502 überprüft. Die entstehende Überprüfungsschleife (Zugriff vom Prozessor auf Speicher und Werte der tatsächlichen zugegriffenen Adresse zurück zum Prozessor) zusammen mit den im Speicher implementierten Mitteln zur Überwachung der Adressierungsschaltung bietet eine höhere Fehlerabdeckung als bekannte Verfahren.

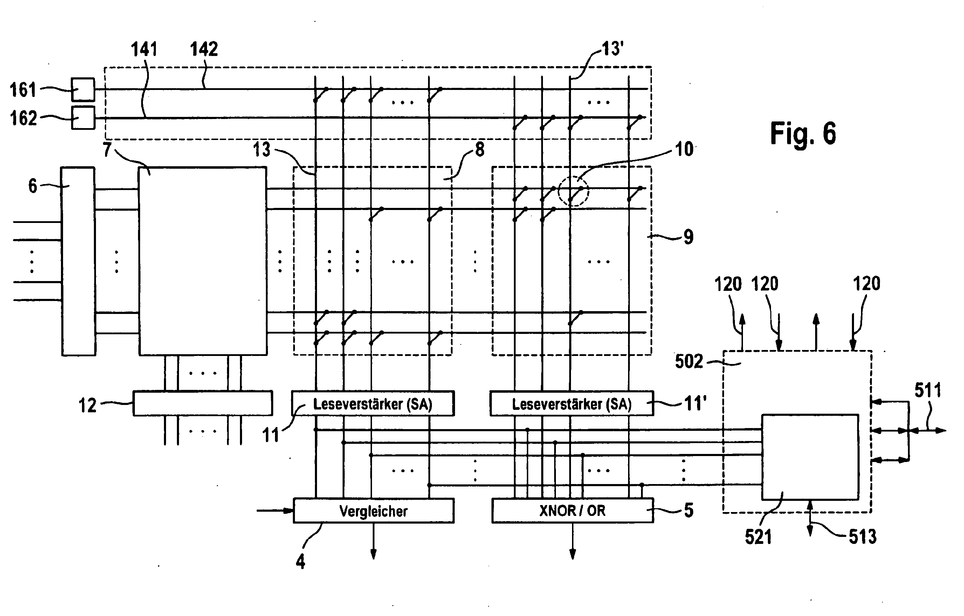

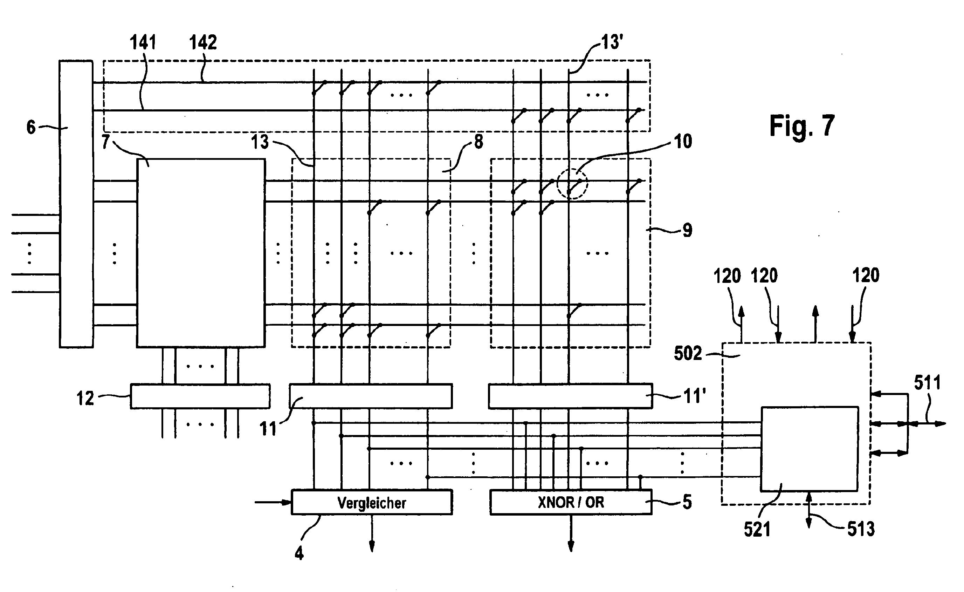

In den Figuren 6 und 7 sind zwei beispielhafte Varianten für Schaltungen zur Überwachung der Speicheradressierungsschaltung innerhalb des Speichers 501 dargestellt. Der grundsätzliche Aufbau des Speichers ist weiter oben im Zusammenhang mit Fig. 2 beschrieben. Die tatsächlich zugegriffene Adresse wird mittels der Echo-Adressleitungen 130 an den Speichercontroller 502 zurückgeführt. Die Rückführung vom Komplementwert der tatsächlich zugegriffenen Adresse erfolgt auf die gleiche Weise (in Fig. 6 nicht dargestellt). Adressierungsfehler können manuell, also als provozierte bzw. stimulierte Fehler, mittels der zusätzlichen Auswahlleitungen 141 und 142 eingespeist werden. Hierfür werden die Leitungstreiber 161 und 162 angeschaltet. Treiber 161 wird mit dem Adressfehlerbit 201 im Adress-Echo Konfigurationsregister 520 angesteuert. Dementsprechend steuert das Komplementärfehlerbit 202 im Adress-Address-Echo Konfigurationsregister 520 den Treiber 162 an.

Die Speicheradressierungsschaltung in Fig. 7 entspricht bis auf den Bereich um Zeilendekodierer 6 der Schaltung in Fig. 6. Für manche Implementierungen kann der dem Speicher zugeordnete Adressraum größer sein, als der tatsächlich implementierte Speicheradressbereich. In diesem Fall sind zwei nicht verwendete Adressleitungen des Zeilendekoders 6 mit den Auswahlleitungen 141 und 142 verbunden. Auf diese Weise können Adressierungsfehler mit dem Adressdecoder provoziert werden. Die Konfigurationsbits Adressfehlerbit 201 und Komplementärfehlerbit 202 werden in der Schaltung gemäß Fig. 7 nicht mehr benötigt.

**Patentansprüche**

1. Datenverarbeitendes System, umfassend einen Halbleiterspeicher (501) mit einer Speichermatrix (7), die von einer Adressierungsschaltung, welche Adressierungsleitungen (1, 1', 1") umfasst, adressiert wird, wobei der Speicher zusätzliche Bitleitungen (13, 13', 31) zum Rückgewinnung der Adresse/ Teiladresse umfasst und das datenverarbeitende System eine Einrichtung zur Erkennung und/oder Korrektur von Adressierungsfehlern mit Vergleichsmitteln (4, 5) zum Vergleich der zurückgelesenen Adresse/Teiladresse und der angelegten Adresse/ Teiladresse umfasst, wobei das datenverarbeitende System einen Mikroprozessor (503) Speicherzugriffsmittel, Adressrücklesemittel und Vergleichsmittel umfasst, mit denen der Mikroprozessor die tatsächliche Speicherzugriffsadresse vom Halbleiterspeicher (501) zurücklesen und überprüfen kann, **dadurch gekennzeichnet, dass** der Halbleiterspeicher eine Adressierungsschaltung mit mindestens einem Rückkopplungspfad zum überprüfen der Adressierungsschaltung aufweist, wobei der Rückkopplungspfad vom Mikroprozessor (503) über einem ersten Bus (510) zur Busmatrix (504), einem zweiten Bus (512) zur Peripheriebrücke (505), über einem Peripheriebus (513) zum Speichercontroller (502) und über die Adress-Echo-Leitungen (130) zum Halbleiterspeicher (501) führt, der zusatzlich zu einem ersten, über einem dritter Bus (511) zwischen der Busmatrix (504) und dem Speicherkontroller (502) führenden pferol vorgesehen ist, wobei die tatsächlich zugegriffene Adresse mittels der Adress-Echo-Leitungen (130) an den Speichercontroller (502) zurückgeführt wird und wobei die Adress-Echo-Leitungen (130) die zwischen Speichercontroller (502) und Speicher (501) vorhandene Schnittstelle (120) erweitern.

2. Datenverarbeitendes System mit einem Halbleiterspeicher nach Anspruch 1, **dadurch gekennzeichnet, dass** Hardware-Unterscheidungsmittel vorgesehen sind, die eine eindeutige Unterscheidung zwischen Datenbitfehlern und Adressierungsfehlern erlauben und/oder eine quantitative Erfassung dieser Fehler ermöglichen.

3. Datenverarbeitendes System mit einem Halbleiterspeicher nach Anspruch 1 oder 2, **dadurch gekennzeichnet, dass** im Kreuzungspunkt zwischen den zusätzlichen Bitleitungen und den Adressierungsleitungen zumindest teilweise Adress-Echo Zellen (1) angeordnet sind.

4. Datenverarbeitendes System mit einem Halbleiterspeicher nach Anspruch 1, 2 oder 3, **dadurch gekennzeichnet, dass** die Abgriffleitungen mit den Eingängen von einem oder mehreren ODER-Gattern (2, 2', 2'', 21, 21', 21'') verbunden sind.

5. Datenverarbeitendes System mit einem Halbleiterspeicher nach mindestens einem der Ansprüche 2 bis 4, **dadurch gekennzeichnet, dass** eine erste Prüfschaltung (4) vorhanden ist, die mit einer zweiten Prüfschaltung (5) verbunden ist, wobei die erste Prüfschaltung die mit den zusätzlichen Bitleitungen rückgewonnenen Adressen/Teiladressen mit den angelegten Adressen/Teiladressen vergleicht und die zweite Prüfschaltung im Gegensatz zur ersten Prüfschaltung komplementärer Adressen/Teiladressen der zusätzlichen Bitleitungen verarbeitet.

6. Datenverarbeitendes System mit einem Halbleiterspeicher nach mindestens einem der Ansprüche 1 bis 5, **dadurch gekennzeichnet, dass** für jede Bitposition in der Adresse eine zusätzliche Bitleitung angelegt ist.

7. Datenverarbeitendes System mit einem Halbleiterspeicher nach mindestens einem der Ansprüche 1 bis 6, **dadurch gekennzeichnet, dass** die Adressierungsleitungen sowohl Zeilen- als auch Spaltenauswahlleitungen umfasst, und diese jeweils mit zusätzlichen Bitleitungen für die Fehlererkennung verbunden sind.

8. Datenverarbeitendes System mit einem Halbleiterspeicher nach mindestens einem der Ansprüche 1 bis 7, **dadurch gekennzeichnet, dass** Hardwaremittel, insbesondere Fehlerspeichermittel, vorhanden sind, mit denen Fehler in den Adressierungsschaltungen nach einem Speicherzugriff erkannt werden können.

9. Datenverarbeitendes System mit einem Halbleiterspeicher nach mindestens einem der Ansprüche 1 bis 8, **dadurch gekennzeichnet, dass** der Halbleiterpeicher mit einem Speichercontroller (502) verbunden ist oder einen Speichercontroller (502) enthält, welcher eines oder mehrere Konfigurationsregister zur Überwachung des Adressdekoders umfasst.

10. Verfahren, welches in einem datenverarbeitenden System mit einem Halbleiterspeicher gemäß mindestens einem der Ansprüche 1 bis 9 durchgeführt wird, wobei die Kernstruktur des Halbleiterspeichers eine Speichermatrix (7) mit Adressierungsleitungen (1, 1', 1'') zum Zugriff auf die einzelnen Speicherzellen der Speichermatrix umfasst, umfassend die Schritte:

   - Abgriff von logischen Pegeln an den Adressierungsleitungen (1, 1', 1''), insbesondere an deren Terminierungen (28),
   - Darstellung der tatsächlich ausgewählten Adresse oder Teiladresse mittels zusätzlicher Adressbitleitungen (13),
   - Rückgewinnung der tatsächlich zugegriffenen Adresse/Teiladresse mit den zusätzlichen Adressbitleitungen (13) und
   - Vergleich der tatsächlich ausgewählten Adresse/Teiladresse mit der aus den zusätzlichen Adressbitleitungen gewonnenen, anliegenden Adresse/Teiladresse zur Erkennung von Fehlern bei der Adressierung des Halbleiterspeichers,

   **gekennzeichnet durch** die Schritte:

   - Verwenden eines Rückkopplungspfads vom Mikroprozessor (503) über den esten Bus (510), die Busmatrix (504), den enweiten Bus (512), die Peripheriebrücke (505), den Peripheriebus (513), den Speichercontroller (502) und die Adress-Echo-Leitungen (130) zum Halbleiterspeicher (501) zur überprüfung des Adressierungsschaltung,
   - Zurückführen der tatsächlich zugegriffenen Adresse mittels der Adress-Echo-Leitungen (130) an den Speichercontroller (502), wobei die Adress-Echo-Leitungen (130) die zwischen Speichercontroller (502) und Speicher (501) vorhandene Schnittstelle (120) erweitern.

11. Verfahren nach Anspruch 10, **dadurch gekennzeichnet, dass** die Rückgewinnung der tatsächlich zugegriffenen Adresse/Teiladresse in Form von Bitkomplementen erfolgt.

12. Verfahren nach Anspruch 10 oder 11, **dadurch gekennzeichnet, dass** eine Unterscheidung zwischen Adressierungsfehlern und Datenbitfehlern vorgenommen wird.

13. Verfahren nach mindestens einem der Ansprüche 11 oder 12, **dadurch gekennzeichnet, dass**

- die Verarbeitung der komplementierten und nicht komplementierten Bits in der Weise erfolgt, dass die komplementierten und nicht komplementierten Bits ODER-Gattern zugeführt werden und/oder
- die Verarbeitung der komplementierten und nicht komplementierten Bits in der Weise erfolgt, dass neben der Speichermatrix (7) eine zusätzliche Kodiermatrix (8) und eine zusätzliche Komplementkodiermatrix (9) vorgesehen ist.

14. Verfahren nach mindestens einem der Ansprüche 10 bis 13, **dadurch gekennzeichnet, dass** die Erkennung eines Adressierungsfehlers im gleichen Zugriffszyklus einer Lese- oder Schreiboperation vorgenommen wird.

15. Verfahren nach mindestens einem der Ansprüche 10 bis 14, **dadurch gekennzeichnet, dass** die bei einem Speicherzugriff tatsächlich zugegriffene rückgelesene Adresse und/oder die komplementäre tatsächlich zugegriffene rückgelesene Adresse in einem oder jeweils einem Register gespeichert werden und ein Speicherzugriff als fehlerfrei angesehen wird, wenn der Registerinhalt der Zugriffadresse bzw. dem Komplement der Zugriffadresse entspricht.

16. Verfahren nach mindestens einem der Ansprüche 10 bis 15, **dadurch gekennzeichnet, dass** Adressierungsfehler als stimulierte Fehler mittels zusätzlicher Auswahlleitungen (141, 142) in den Halbleiterspeicher eingespeist werden.

## Claims

1. Data processing system, comprising a semiconductor memory (501) with a memory matrix (7) which is addressed by an addressing circuit which comprises addressing lines (1, 1', 1"), wherein the memory comprises additional bit lines (13, 13', 31) for recovering the address/subaddress, and the data processing system comprises a device for recognizing and/or correcting addressing errors with comparison means (4, 5) for comparing the read-back address/subaddress and the applied address/subaddress, wherein the data processing system comprises a microprocessor (503), memory access means, address read-back means and comparison means which the microprocessor can use to read back and check the actual memory access address from the semiconductor memory (501), **characterized in that** the semiconductor memory has an addressing circuit having at least one feedback path for checking the addressing circuit, wherein the feedback path is routed from the microprocessor (503) via a first bus (510) to the bus matrix (504), a second bus (512) to the peripheral bridge (505), via a peripheral bus (513) to the memory controller (502) and via the address echo lines (130) to the semiconductor memory (501), which is provided in addition to a first path routed via a third bus (511) between the bus matrix (504) and the memory controller (502), wherein the actually accessed address is returned to the memory controller (502) by means of the address echo lines (130) and wherein the address echo lines (130) extend the interface (120) which is present between the memory controller (502) and the memory (501).

2. Data processing system having a semiconductor memory according to Claim 1, **characterized in that** hardware distinguishing means are provided which allow explicit distinction between data bit errors and addressing errors and/or allow quantitative detection of these errors.

3. Data processing system having a semiconductor memory according to Claim 1 or 2, **characterized in that** the crossover point between the additional bit lines and the addressing lines contains address echo cells (1) at least to some extent.

4. Data processing system having a semiconductor memory according to Claim 1, 2 or 3, **characterized in that** the tap-off lines are connected to the inputs of one or more OR gates (2, 2', 2", 21, 21', 21").

5. Data processing system having a semiconductor memory according to at least one of Claims 2 to 4, **characterized in that** a first test circuit (4) is present which is connected to a second test circuit (5), wherein the first test circuit compares the addresses/subaddresses recovered using the additional bit lines with the applied addresses/subaddresses, and the second test circuit, in contrast to the first test circuit, processes complementary addresses/subaddresses from the additional bit lines.

**6.** Data processing system having a semiconductor memory according to at least one of Claims 1 to 5, **characterized in that** an additional bit line is applied for each bit position in the address.

**7.** Data processing system having a semiconductor memory according to at least one of Claims 1 to 6, **characterized in that** the addressing lines comprise both row selection lines and column selection lines, and these are respectively connected to additional bit lines for error recognition.

**8.** Data processing system with a semiconductor memory according to at least one of Claims 1 to 7, **characterized in that** hardware means, particularly error storage means, are present which can be used to recognize errors in the addressing circuits following a memory access operation.

**9.** Data processing system with a semiconductor memory according to at least one of Claims 1 to 8, **characterized in that** the semiconductor memory is connected to a memory controller (502) or contains a memory controller (502) which comprises one or more configuration registers for monitoring the address decoder.

**10.** Method which is carried out in a data processing system having a semiconductor memory according to at least one of Claims 1 to 9, wherein the core structure of the semiconductor memory comprises a memory matrix (7) having addressing lines (1, 1', 1") for accessing the individual memory cells in the memory matrix, comprising the following steps:

- logic levels on the addressing lines (1, 1', 1"), particularly on the terminations (28) thereof, are tapped off,
- the actually selected address or subaddress is represented by means of additional address bit lines (13),
- the actually accessed address/subaddress is recovered using the additional address bit lines (13), and
- the actually selected address/subaddress is compared with the applied address/subaddress, obtained from the additional address bit lines, in order to recognize errors in the addressing of the semiconductor memory,

**characterized by** the following steps:

- a feedback path from the microprocessor (503) via the first bus (510), the bus matrix (504), the second bus (512), the peripheral bridge (505), the peripheral bus (513), the memory controller (502) and the address echo lines (130) to the semiconductor memory (501) is used to check the addressing circuit,
- the actually accessed address is returned by means of the address echo lines (130) to the memory controller (502), wherein the address echo lines (130) extend the interface (120) which is present between the memory controller (502) and the memory (501).

**11.** Method according to Claim 10, **characterized in that** the actually accessed address/subaddress is recovered in the form of bit complements.

**12.** The method according to Claim 10 or 11, **characterized in that** a distinction is drawn between addressing errors and data bit errors.

**13.** The method according to at least one of Claims 11 and 12, **characterized in that**

- the complemented and uncomplemented bits are processed such that the complemented and uncomplemented bits are supplied to OR gates, and/or
- the complemented and uncomplemented bits are processed such that besides the memory matrix (7) an additional encoding matrix (8) and an additional complement encoding matrix (9) are provided.

**14.** Method according to at least one of Claims 10 to 13, **characterized in that** an addressing error is recognized in the same access cycle as a read or write operation.

**15.** Method according to at least one of Claims 10 to 14, **characterized in that** the read-back address actually accessed during a memory access operation and/or the complementary actually accessed read-back address is/are stored in a or a respective register, and a memory access operation is considered error-free if the register content corresponds to the access address or to the complement of the access address.

**16.** Method according to at least one of Claims 10 to 15, **characterized in that** addressing errors are supplied to the semiconductor memory as stimulated errors by means of additional selection lines (141, 142).

**Revendications**

**1.** Système de traitement de données comprenant une mémoire (501) à semi-conducteur dotée d'une matrice de mémoire (7) adressée par un circuit d'adressage qui comporte des conducteurs d'adressage (1, 1', 1"),

la mémoire comprenant des conducteurs de bits supplémentaires (13, 13', 31) permettant de récupérer une adresse ou une partie d'adresse et le système de traitement de données comportant un dispositif de détection et/ou de correction d'erreurs d'adressage doté de moyens de comparaison (4, 5) qui comparent l'adresse ou la partie d'adresse lues et l'adresse ou la partie d'adresse appliquées,

le système de traitement de données comprenant un microprocesseur (503), des moyens d'accès à la mémoire, des moyens de lecture d'adresse et des moyens de comparaison à l'aide desquels le microprocesseur peut lire et vérifier l'adresse effective d'accès à la mémoire (501) à semi-conducteur, **caractérisé en ce que**

la mémoire à semi-conducteur présente un circuit d'adressage qui présente au moins un parcours de rétroaction permettant de vérifier le circuit d'adressage, le parcours de rétroaction conduisant du microprocesseur (503) à la matrice de bus (504) par l'intermédiaire d'un premier bus (510), au pont périphérique (505) par un deuxième bus (512), au contrôleur (502) de la mémoire par un bus périphérique (513) et à la mémoire (501) à semi-conducteur par l'intermédiaire des conducteurs (130) d'écho d'adresse, le parcours de rétroaction étant prévu en plus d'un premier parcours qui passe par un troisième bus (511) situé entre la matrice de bus (504) et le contrôleur (502) de la mémoire, l'adresse par laquelle on accède effectivement étant renvoyée au moyen des conducteurs (130) d'écho d'adresse au contrôleur (502) de la mémoire, les conducteurs (130) d'écho d'adresse complétant l'interface (120) prévue entre le contrôleur (502) de la mémoire et la mémoire (501).

2. Système de traitement de données doté d'une mémoire à semi-conducteur selon la revendication 1, **caractérisé en ce qu'**il présente des moyens électroniques de distinction qui permettent de distinguer clairement entre des erreurs de bits de données et des erreurs d'adressage et/ou qui permettent une saisie quantitative de ces erreurs.

3. Système de traitement de données doté d'une mémoire à semi-conducteur selon les revendications 1 ou 2, **caractérisé en ce que** des cellules (1) d'écho d'adresse sont prévues en au moins certains points de croisement entre les conducteurs de bits supplémentaires et les conducteurs d'adressage.

4. Système de traitement de données doté d'une mémoire à semi-conducteur selon les revendications 1, 2 ou 3, **caractérisé en ce que** les conducteurs de reprise sont reliés aux entrées d'une ou de plusieurs portes OU (2, 2', 2" , 21, 21', 21").

5. Système de traitement de données doté d'une mémoire à semi-conducteur selon au moins l'une des revendications 2 à 4, **caractérisé en ce qu'**un premier circuit de vérification (4) relié à un deuxième circuit de vérification (5) est prévu, le premier circuit de vérification comparant les adresses ou parties d'adresses obtenues à l'aide des conducteurs de bits supplémentaires aux adresses ou parties d'adresses appliquées et le deuxième circuit de vérification traitant à la différence du premier circuit de vérification les adresses ou parties d'adresses complémentaires des conducteurs de bits supplémentaires.

6. Système de traitement de données doté d'une mémoire à semi-conducteur selon au moins l'une des revendications 1 à 5, **caractérisé en ce qu'**un conducteur de bits supplémentaire est prévu pour chaque position de bit d'adresse.

7. Système de traitement de données doté d'une mémoire à semi-conducteur selon au moins l'une des revendications 1 à 6, **caractérisé en ce que** les conducteurs d'adressage comprennent à la fois des conducteurs de sélection de lignes et des conducteurs de sélection de colonnes qui sont tous reliés à des conducteurs de bits supplémentaires servant à la détection des erreurs.

8. Système de traitement de données doté d'une mémoire à semi-conducteur selon au moins l'une des revendications 1 à 7, **caractérisé en ce que** des moyens électroniques, en particulier des moyens de mémorisation d'erreur, sont prévus et permettent de détecter des erreurs dans les circuits d'adressage après un accès à la mémoire.

9. Système de traitement de données doté d'une mémoire à semi-conducteur selon au moins l'une des revendications 1 à 8, **caractérisé en ce que** la mémoire à semi-conducteur est reliée à un contrôleur (502) de mémoire ou contient un contrôleur (502) de mémoire qui comporte un ou plusieurs registres de configuration qui surveillent le codeur d'adresses.

10. Procédé exécuté dans un système de traitement de données doté d'une mémoire à semi-conducteur selon au moins l'une des revendications 1 à 9, la structure d'âme de la mémoire à semi-conducteur comprenant une matrice de mémoire (7) dotée de conducteurs d'adressage (1, 1', 1") qui permettent d'accéder aux différentes cellules de la matrice de mémoire, et comportant les étapes qui consistent à :

- prélever les niveaux logiques des conducteurs d'adressage (1, 1', 1"), en particulier à leurs extrémités (28),
- présenter l'adresse ou la partie d'adresse effectivement sélectionnées au moyen de conducteurs supplémentaires d'adressage (13),
- récupérer à l'aide des conducteurs supplémentaires d'adressage (13) l'adresse ou la partie d'adresse effectivement prélevées et
- comparer l'adresse ou la partie d'adresse effectivement sélectionnées à une adresse ou partie d'adresse obtenues sur les conducteurs supplémentaires d'adressage pour détecter des erreurs d'adressage de la mémoire à semi-conducteur,

**caractérisé par** les étapes qui consistent à :

- utiliser un parcours de rétroaction entre le microprocesseur (503) et la mémoire (501) à semi-conducteur par l'intermédiaire du premier bus (510), de la matrice de bus (504), du deuxième bus (512), du pont périphérique (505), du bus périphérique (513), du contrôleur de mémoire (502) et des conducteurs (130) d'écho d'adresse pour vérifier le circuit d'adressage,
- renvoyer l'adresse effectivement prélevée au contrôleur (502) de la mémoire au moyen des conducteurs (130) d'écho d'adresse, les conducteurs (130) d'écho d'adresse complétant l'interface (120) prévue entre le contrôleur (502) de la mémoire et la mémoire (501).

11. Procédé selon la revendication 10, **caractérisé en ce que** la récupération de l'adresse ou de la partie d'adresse effectivement prélevée s'effectue sous la forme de compléments de bits.

12. Procédé selon les revendications 10 ou 11, **caractérisé en ce qu'**une distinction est réalisée entre les erreurs d'adressage et les erreurs de bits de données.

13. Procédé selon au moins l'une des revendications 11 ou 12, **caractérisé en ce que** le traitement des bits complémentaires et des bits non complémentaires s'effectue en amenant les bits complémentaires et les bits non complémentaires à des portes OU et/ou **en ce que** le traitement des bits complémentaires et des bits non complémentaires s'effectue en prévoyant en plus de la matrice de mémoire (7) une matrice supplémentaire de codage (8) et une matrice supplémentaire de codage complémentaire (9).

14. Procédé selon au moins l'une des revendications 10 à 13, **caractérisé en ce que** la détection d'une erreur d'adressage est réalisée dans le même cycle d'accès d'une opération de lecteur ou d'écriture.

15. Procédé selon au moins l'une des revendications 10 à 14, **caractérisé en ce que** l'adresse lue prélevée effectivement et/ou l'adresse complémentaire lue prélevée effectivement lors d'un accès à la mémoire sont conservées dans un registre ou chacune dans un registre particulier et **en ce qu'**un accès à la mémoire est considéré comme exempt d'erreur si le contenu de l'adresse d'accès correspond au complément de l'adresse d'accès.

16. Procédé selon au moins l'une des revendications 10 à 15, **caractérisé en ce que** les erreurs d'adressage sont injectées en tant qu'erreurs stimulées dans la mémoire à semi-conducteur, au moyen de conducteurs supplémentaires de sélection (141, 142).

# Fig. 1

(Zeilen- oder Spalten-)
Auswahlleitung
1

A
B
C
D
E
F
G
H

31

Nicht-exclusive
ODER Funktion

3

ODER 2
Gatter

2'

2''

eZ

eY

eX

XNOR

eZc

eYc

eXc

21

21'

21''

Angelegte
Adressbit

X
Y
Z

Vergleicher

22

23

Adressfehler

20

4
Erste
Konsistenzprüfung

5
Zweite
Konsistenzprüfung

## Fig. 2

**Kodierung der Zeilenadresse** 8

**Kodierung des Komplements der Zeilenadresse** 9

Bitleitung 13

13'

24

1'

10

Adress-Echo Zelle

6

7

Zeilendekodierer

8 x 8 Bitmatrix

A B C D E F G H

A B C D E F G H

X
Y
Z

Adress-leitungen

Lese-verstärker für Adresse

eX | eY | eZ

eXc | eYc | eZc

12 — Datenleseverstärker

Leseverstärker — 11

Leseverstärker

Leseverstärker für Daten

8 Datenbit

11'

Adress-leitungen

X
Y
Z

Vergleicher

XNOR / OR — 5

4

Adressfehler

Adressfehler

## Fig. 3

Bitleitung

13

Zeilen-auswahlleitung

10

1

MOS Transistor

24

Masse (GND)

25

**Fig. 4**

Zeilendekodierer

Spaltendekodierer

$\log_2(Q)$

$\log_2(P)$

P = ColMux Faktor

Lesen/Schreiben Control

Leseverstärker/Treiberstufe (SAD)

$B_N$ in $B_N$ out

$B_0$ in $B_0$ out

Leseverstärker (SA)

Vergleicher

Angelegte Zeilenadresse

XNOR / OR

Adressfehler

7a.N

7a.0

Fig. 5

EP 2 100 308 B1

Fig. 6

EP 2 100 308 B1

Fig. 7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6754858 B
- DE 4317175 A1
- US 4912710 A
- EP 1662511 A1

### In der Beschreibung aufgeführte Nicht-Patentliteratur

- **M. Nicolaidis.** Efficient UBIST Implementation for Microprocessor Sequential Partys. *IEEE International Test Conference,* Juni 1990